# EUROPEAN PATENT APPLICATION

(11) **EP 2 006 777 A1**
(43) Date of publication of application: **24.12.2008**
(21) Application number: 08164183.9
(22) Date of filing: 16.10.2006
(51) Int. Cl.: G06F 13/38, G06F 13/42

(54) **Bus inverting code generating apparatus and method of generating bus inverting code using the same**

(30) Priority: 01.06.2006 KR 20060049512
(62) Divisional of application: 06122363.2
(71) Applicant: Samsung Electronics Co., Ltd., Suwon-si, Gyeonggi-do 442-742 (KR)
(72) Inventor: Rhim, Sang Woo, Gyeonggi-do 449-712 (KR); Kim, Eui Seok, Gyeonggi-do 449-712 (KR); Lee, Beom Hak, Gyeonggi-do 449-712 (KR)
(74) Representative: Ertl, Nicholas Justin

(57) **Abstract**

A bus inverting code generating apparatus and a method of generating bus inverting code is provided. The bus inverting code generating apparatus includes a bit comparator comparing present input data with previous input data for each bit and outputs a bit comparison result; a bit counter counting bits of the bit comparison result and outputs a bit count result;; an indicator toggling an indicator output if the bit count result that is output by the bit counter is greater than a reference value; and an inverting determiner outputting an inverting signal indicating whether the present input data is inverted based on the bit count result and the indicator output.

## Description

### BACKGROUND OF THE INVENTION

Apparatuses and methods consistent with the present invention relate to a bus inverting code (BIC), and more particularly, to a BIC method and apparatus capable of being applied to a network interface (NI).

A bus inverting code (BIC) is used for minimizing power consumption by reducing a number of bit transitions of a transmitted/received signal. The BIC reduces transition of a transmitted/received signal by outputting inverted data while outputting present data when there is a large number of bits that have to be transitioned with respect to previously outputted data.

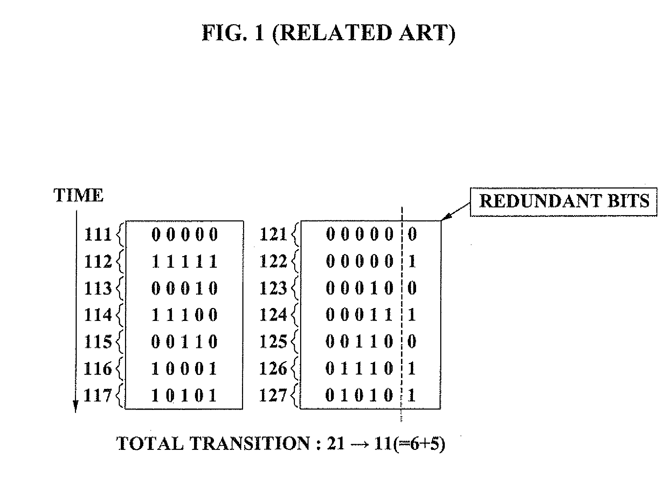

FIG. 1 is a diagram illustrating an example of a BIC. Referring to FIG. 1, when a BIC is not applied and five bits of data are outputted, binary numbers "00000" 111, "11111" 112, "00010" 113, "11100" 114, "00110" 115, "10001" 116, and "10101" 117 are sequentially outputted. Accordingly, when the BIC is not applied, there are a total of 21 bit transitions.

In this example, when the BIC is applied, a binary number "11111" is not outputted after a binary number "00000" 121 and a binary number "00000" 122 is outputted by inverting the binary number "11111" 112. In addition, a binary number "11100" is not outputted as it is after a binary number "00010" 123 and a binary number "00011" 124 is outputted by inverting the binary number "11100" 114. Also, a binary number "10001" is not outputted as it is after a binary number "00110" 125 and a binary number "01110" 126 is outputted by inverting the binary number "10001" 116. Finally, a binary number "01010" 127 is outputted by inverting the binary number "10101" 117. Accordingly, there are a total of 11 bit transitions when applying the BIC, which is greatly reduced from the 21 bit transitions that are required when the BIC is not applied.

In this case, an additional bit indicating whether corresponding data has been inverted is necessary when the BIC is applied. However, to apply the BIC as described above, additional clock cycles are required to be consumed for determining whether data is inverted, and the additional bit for indicating whether the data is inverted is required.

Accordingly, there is a need for a BIC generating method and apparatus that are capable of quickly determining whether data is inverted and eliminating the additional bit requirement.

### SUMMARY OF THE INVENTION

The present invention provides a BIC generating method and apparatus capable of quickly generating a BIC by reducing a number of clock cycles consumed in determining whether data is inverted.

The present invention also provides a BIC generating method and apparatus capable of quickly generating a BIC by comparing bits when an inversion of previous input data is not recognized.

The present invention also provides a BIC generating method and apparatus capable of simply and efficiently counting bits by grouping two or more bits into one group for counting bits.

The present invention also provides a BIC generating method and apparatus capable of effectively generating a BIC by determining a suitable reference value when binding two or more bits into one group.

The present invention also provides a BIC generating method and apparatus capable of transmitting information about whether data is inverted to a receiving side without assigning additional bits, by using a flit type bit.

The present invention also provides a BIC generating method and apparatus capable of effectively generating a BIC when generating a packet for a network interface (NI) to effectively perform on-chip networking.

According to an aspect of the present invention, there is provided a BIC generating apparatus including: a bit comparator which compares present input data with previous input data for each bit and outputs a bit comparison result; a bit counter which counts bits of the bit comparison result that is output by the bit comparator and outputs a bit count result; an indicator which generates an indicator value and toggles the indicator value if the bit count result that is output by the bit counter is greater than a reference value; and an inverting determiner that outputs an inverting signal that indicates whether the present input data is inverted based on the bit count result and the indicator value.

The inverting determiner may output the inverting signal to invert the input data if the bit count result is greater than the reference value and the indicator value is a first level, or the bit count result is less than the reference value and the indicator value is the first level.

The inverting determiner may output the inverting signal to not invert the input data if the bit count result is greater than the reference value and the indicator value is the second level, or the output result of the bit counter is less than the reference value and indicator value is the second level.

The bit counter may count the bits of the output result by performing an add operation between groups by grouping the bits of the bit comparison result into groups of at least two bits.

The inverting signal may be transmitted to a receiving side by using a flit type bit of the input data.

The inversion may be performed only with respect to a data flit.

The first level may be a logical high level and the second level may be a logical low value.

The apparatus may further comprise a register that stores the present input data.

The present input data that is stored in the register may be stored as the previous input data, and the register may store new input data as the present input data. Further, the register may replace the previous input data with the present input data each time the inverting determiner outputs the inverting signal.

According to another aspect of the present invention, there is provided a BIC method including: generating a bit comparison result by comparing present input data with previous input data for each bit; counting bits of the bit comparison result to generate a bit count result; toggling an indicator output if the bit count result is greater than a reference value; and outputting an inverting signal that indicates whether the present input data is inverted based on the bit count result and the indicator value.

The BIC method and apparatus may be used in generating a packet for an on-chip interconnection.

The BIC method and apparatus may be applied to a network interface.

### BRIEF DESCRIPTION OF THE DRAWINGS

The above and other aspects of the present invention will become apparent and more readily appreciated from the following detailed description of exemplary embodiments, taken in conjunction with the accompanying drawings of which:
FIG. 1 is a diagram illustrating an example of a BIC according to the related art;
FIG. 2 is a block diagram illustrating a BIC generating apparatus according to an exemplary embodiment of the present invention;
FIG. 3 is a flowchart of operations of an inverting determiner shown in FIG. 2;
FIG. 4 is a diagram illustrating a BIC generating method according to an exemplary embodiment of the present invention;
FIG. 5 is a diagram illustrating counting an output result for each bit, according to an exemplary embodiment of the present invention;
FIG. 6 is a diagram illustrating an on-chip interconnection according to an exemplary embodiment of the present invention; and
FIG. 7 is a flowchart of the BIC generating method according to an exemplary embodiment of the present invention.

### DETAILED DESCRIPTION OF THE EXEMPLARY EMBODIMENTS OF THE INVENTION

Reference will now be made in detail to exemplary embodiments of the present invention, examples of which are illustrated in the accompanying drawings, wherein like reference numerals refer to the like elements throughout. The exemplary embodiments are described below to explain the present invention by referring to the figures.

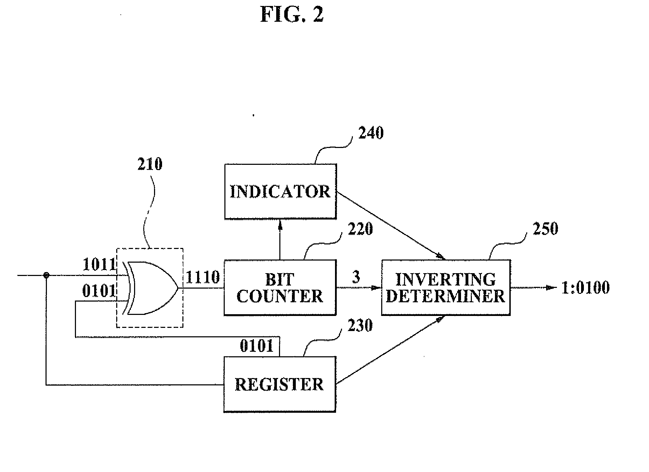

FIG. 2 is a block diagram illustrating a BIC generating apparatus according to an exemplary embodiment of the present invention. Referring to FIG. 2, the BIC generating apparatus includes a bit comparator 210, a bit counter 220, a register 230, an indicator 240, and an inverting determiner 250.

The bit comparator 210 compares input data with previous input data for each bit. For example, the bit comparator 210 may output a binary number "1110" by receiving a binary number "1011" and a binary number "0101". In this case, the bit comparator 210 may be an exclusive OR gate.

The bit counter 220 counts bits of an output result of the bit comparator 210. For example, the bit counter 220 may count a number of binary "1" bits of the output result of the bit comparator 210. Namely, the bit counter 220 may output 3 by counting the number of binary "1" bits in a binary number "1110" that is an output result of the bit comparator 210.

The register 230 outputs previous input data by storing input data. For example, when a binary number "1011" is input as present input data, the register 230 outputs a binary number "0101", which is the previous input data, to enable the bit comparator 220 to compare each bit of the present input data with the previous input data.

The indicator 240 outputs a first level or a second level by using an output result of the bit counter 220. The first level may be a logical "1" and the second level may be a logical "0". The indicator 240 may toggle the output when the output result of the bit counter 220 is greater than a predetermined reference value.

The indicator may be initialized as a binary "0" or may be initialized as a binary "1". As an example, the predetermined reference value may be 2 when input data is four bits wide. Thus, in this example, when the output result of the bit counter 220 is 3, and since 3 is greater than the predetermined reference value of 2, the indicator 240 may toggle an output initialized as binary "0" to binary "1".

In this case, the indicator 240 may be embodied as a simple logic circuit using a multiplexer. For example, the indicator 240 may use a multiplexer that receives an output from the bit counter 220 as an input according to a result of comparing an input value with a predetermined reference value via the bit comparator or receiving a signal made by inverting the output as the input.

The inverting determiner 250 outputs an inverting signal that indicates whether present input data is inverted based on the output of the bit counter 220 and the indicator 240. For example, in the inverting signal, a binary "1" may indicate that the present input data is inverted and a binary "0" may indicate that the present input data is not inverted. As another example, in the inverting signal, a binary number "11" may indicate that the present input data is inverted and another binary number "00" may indicate that the present input data is not inverted.

In an exemplary embodiment, the inverting determiner 250 may output data together with the inverting signal. As an example, the inverting determiner 250 may output a binary "1" as the inverting signal to indicate that the present input data is inverted, and the inverting determiner 250 may output a binary number "0100" as the output data, made by inverting a binary number "1011", which is the present input data.

The bit comparator 210 compares previous input data with the present input data for each bit regardless of whether the present input data is inverted, thereby reducing clock cycle consumption. Also, the inverting determiner 250 may generate a BIC to effectively invert the input data by referring to the output result of the indicator 240.

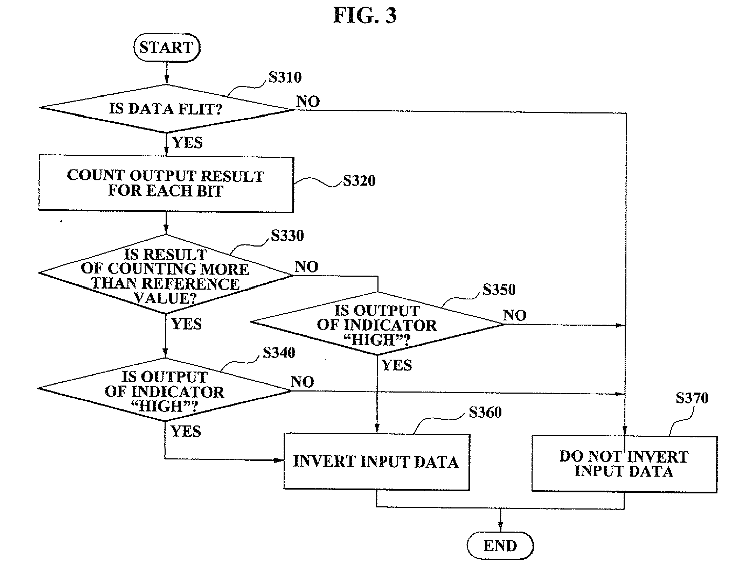

FIG. 3 is a flowchart of the operations of the inverting determiner 250 shown in FIG. 2. In this case, in operation S340 and operation S350 of determining whether the output of the indicator 240 is "high" may be established by toggling the output from "high" to "low" and from "low" to "high", according to an initial set value of the indicator 240. In FIG. 3, the output of the indicator 240 is initialized as "low".

Referring to FIG. 3, the inverting determiner 250 determines whether input data corresponds to a data flit (S310).

When the input data does not correspond to the data flit as a result of the determination performed in operation S310, the inverting determiner 250 outputs an inverting signal to indicate that the present input data is not to be inverted (S370).

When the input data is determined to correspond to the data flit as the result of the determination performed in operation S310, the inverting determiner 250 receives a result of counting by the bit counter 220 (S320).

In this case, the result of counting may be a result of counting a number of binary "1" bits from an output of the bit comparator 210. For example, when the output of the bit comparator 210 is a binary number "0101", the result of counting may be 2, which is the number of binary "1" bits in the binary number "0101".

Also, the result of counting may be a result of dividing the output of the bit comparator 210 into groups made by binding two or more bits and adding the group. For example, when the output of the bit comparator 210 is a binary "01011111", the result of counting may be 8, which is determined by dividing the output of the bit comparator 210 into groups of two bits, such as binary numbers "01", "01", "11", and "11", considering each group as one number, such as base 10 numbers 1, 1, 3, and 3, and adding the numbers (i.e., 1 + 1 + 3 + 3).

Also, the inverting determiner 250 determines whether the result of counting is greater than a reference value (S330).

For example, when the result of counting is a result of counting a number of binary "1" bits from the output of the bit comparator 210, the reference value may be one half of a number of input bits.

For instance, when the result of counting is a result of dividing the output of the bit comparator 210 into the groups of two or more bits and adding each result, the reference value may be corresponding to a value obtained by dividing a result of multiplying a maximum value of the groups by the number of the bits of the input data, by two times the number of the bits in the groups. As an example of such a reference value, when the group includes two bits and the number of the bits of the input data is 32, the reference value may be (3 × 32)/(2 × 2) = 24.

When the determination performed in operation S330 indicates that the result of counting is greater than the reference value, the inverting determiner 250 determines whether an output of the indicator 240 is a first level (S340). In this case, the first level may be logical "high" or a binary "1".

When the result of the determination performed in operation S340 indicates that the output of the indicator 240 is the first level, the inverting determiner 250 outputs the inverting signal so as to invert the present input data (S360).

When the result of the determination performed in operation S330 indicates the counting is less than the reference value, the inverting determiner 250 determines whether the output of the indicator 240 is the first level (S350). In this case, the first level may be a logical "high" or a binary "1".

When the output of the indicator 240 is determined to be the first level in operation S350, the inverting determiner 250 outputs the inverting signal so as to invert the present input data (S360).

When the output of the indicator 240 is determined not to be the first level in operation S350, the inverting determiner 250 outputs the inverting signal to not invert the present input data (S370).

When the output of the indicator 240 is determined not to be the first level in operation S340, the inverting determiner 250 outputs the inverting signal to not invert the present input data (S370).

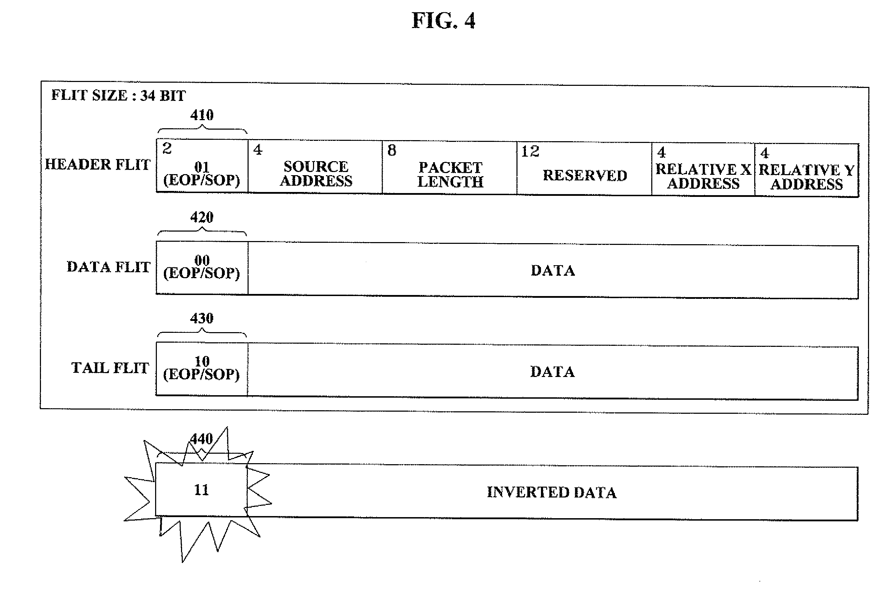

FIG. 4 is a diagram illustrating a BIC generating method according to an exemplary embodiment of the present invention.

Referring to FIG. 4, a flit includes 34 bits. In this example, upper two bits of the flit are flit type bits indicating a type of the flit. Namely, the flit includes two flit type bits and 32 data bits.

As shown in FIG. 4, binary number "01" 410 is assigned to indicate a header flit, binary number "00" 420 is assigned to indicate a data flit, and binary number "10" 430 is assigned to indicate a tail flit, as an example for the flit type bits. In this case, since a flit type corresponding to a binary number "11" 440 is an undefined flit type, in the present exemplary embodiment, the input data may be indicated as being inverted by using the binary number "11" 440 as the flit type bits.

Namely, the binary number "00" 410 may indicate a data flit that is not inverted and "11" 440 may indicate an inverted data flit.

In this case, an established value of the flit type shown in FIG. 4 is just an example. Values of the header flit, the data flit, and the inverted data flit, and the tail flit may be established as various combinations of four binary values "00", "01", "10", and "11".

By using AHB™ (Advanced High-Performance Bus) and AXI™ (Advanced extensible Interface) bus protocols, a maximum data burst of 16 bytes may be sequentially transmitted. The data may include 15 data flits and one tail flit. In this case, the tail flit is not inverted regardless of whether inverting is required.

As described above, when transmitting an inverting signal by using flit type bits, there is no need to assign an additional bit.

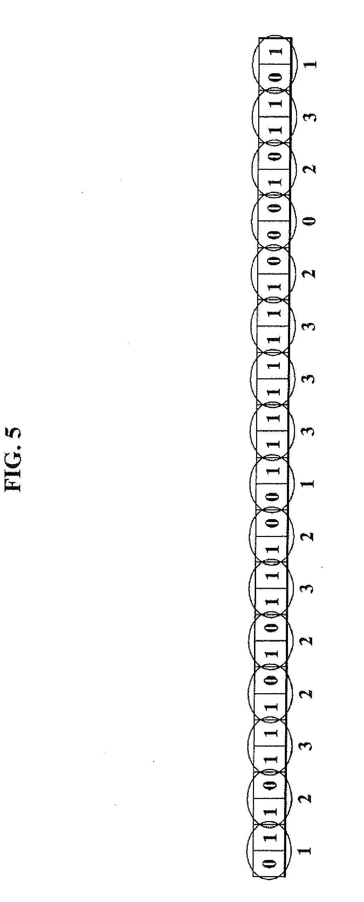

FIG. 5 is a diagram illustrating counting bits of an output result, according to an exemplary embodiment of the present invention. Referring to FIG. 5, the bit comparator 210 outputs a 32 bit signal "01101110101110011111111000101101" as an output result for counting bits.

In this case, according to an exemplary embodiment of the present invention, the output result for counting bits is divided into groups of two bits and a summation of the groups are performed. Namely, instead of adding the respective bits shown in FIG. 5, the group of two bits is considered as one number and the add operation is performed group by group.

In FIG. 5, a result of counting the groups of the output result is 1 + 2 + 3 + 2 + 2 + 3 + 2 + 1 + 3 +3 + 3 + 2 + 0 + 2 + 3 + 1 = 33.

As described above, when performing the summation of the groups, since a number of add operations can be reduced compared to when performing add operations with respect to each individual bit, the summation may be performed at high speed. For example, in the case of a 32 bit signal, five operations are required when adding each individual bit one by one, four operations are required when adding groups of two bits, three operations are required when adding groups of four bits, and only two operations are required when adding groups of eight bits.

In this case, when dividing the bits of the output result into groups and performing add operations between the groups, a reference value for comparison with the group of bits of the output result has to be suitably determined.

According to an exemplary embodiment of the present invention, the group of bits of the output result may include a number of bits, corresponding to a power of 2, and the reference value may be corresponding to a value obtained by dividing a result of multiplying a maximum value of the group by a number of bits of input data, by two times of a number of bits in the group.

For example, when an output result for each bit is 32 bits, a number of bits of input data is 32. When dividing the output result for each bit into groups of two bits, a number of bits of the group is 2 and a maximum value of the group is a binary "11" = 3. Accordingly, in this case, a reference value may be (3 × 32) / (2 × 2) = 24.

Generally, when counting the bits of the output result, a greater number of bits of input data results in a greater burden when generating a BIC. According to an exemplary embodiment of the present invention, when dividing the output result into groups and performing add operations group by group, a load with respect to counting the output result for each bit may be greatly reduced when a number of input data is large.

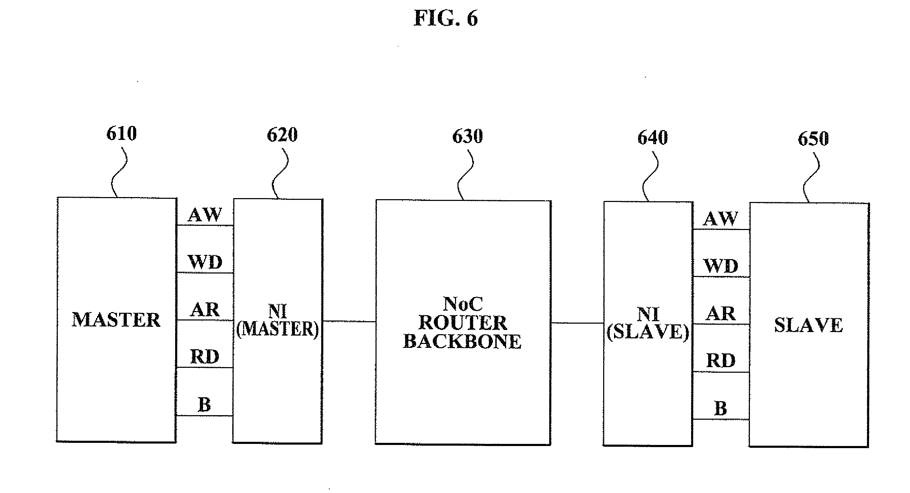

FIG. 6 is a diagram illustrating an on-chip interconnection (OSI) according to an exemplary embodiment of the present invention. Referring to FIG. 6, a master apparatus 610 and a slave apparatus 650 communicate with each other via a network on-chip (NoC) router backbone 630 by packetizing a transmitted/received signal via network interfaces (NI) 620 and 640.

In this case, the master apparatus 610 and the slave apparatus 650 may be an AXI™ master and an AXI™ slave, respectively, or an AHB™ master and an AHB™ slave, respectively. In addition, the present invention may be applied to various other bus protocols such as Open Core Protocol (OCP), etc.

In this case, the BIC generating apparatus shown in FIG. 2 may be included in the NIs 620 and 640.

Signals generated by the master apparatus 610 are bus-inverted in the master NI 620 and are bus-decoded in the slave NI 640. Conversely, signals generated by the slave apparatus 650 are bus-inverted in the slave NI 640 and are bus-decoded in the master NI 620.

In bus-decoding, the signals are outputted as is when flit type bits are binary "00" and inverted when the flit type bits are binary "II".

In this case, the NIs 620 and 640 may enable a control signal or an address signal to not be inverted.

As described above, by applying the BIC generating apparatus according to an exemplary embodiment of the present invention to the NIs 620 and 640, data communication may be performed without additional correction by the NoC router backbone 630.

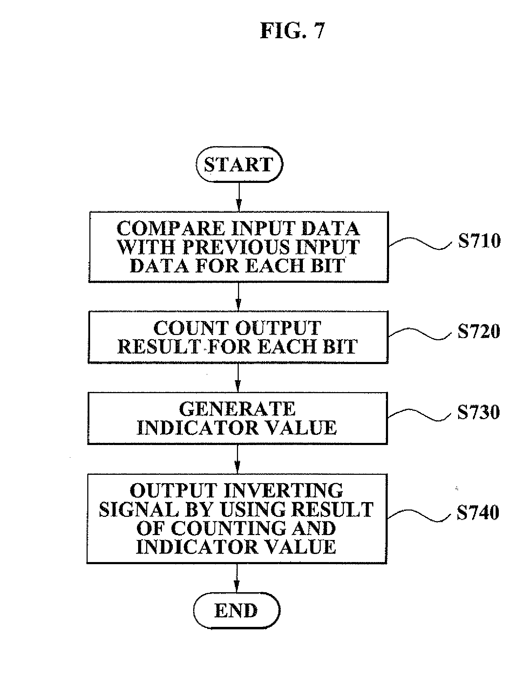

FIG. 7 is a flowchart of the BIC generating method according to an exemplary embodiment of the present invention.

Referring to FIG. 7, an output result is generated by comparing present input data with previous input data, for each bit (S710).

The bits of the output result are counted (S720). In this case, in operation S720, the output result for each bit may be divided into groups of two or more bits and an add operation between the groups may be performed to count the output result for each bit. In this case, the group of bits of the output result may include a number of bits corresponding to a power of 2, and a predetermined reference value may be corresponding to a value obtained by dividing a result of multiplying a maximum value of the group by a number of bits of input data, by two times of a number of bits in the group.

When a result of counting the output result for each bit is greater than the predetermined reference value, an indicator value is generated by toggling the indicator value (S730).

For example, when the result of counting the output result for each bit is greater than the predetermined value, the indicator value is changed into a binary "0" from a binary "1" or changed into a binary "1" from a binary "0".

An inverting signal indicating whether the present input data is inverted is outputted by using the result of counting the output result for each bit and the indicator value (S740).

In this case, in S740, the inverting signal may be outputted to invert the input data when the result of counting the output result for each bit is greater than the reference value and an output of an indicator is a first level, or when the result of counting the bits of the output result is less than the reference value, the output of the indicator is a second level, and the input data is not a tail flit.

In this case, in operation S740, the inverting signal may be outputted so as to indicate that the present input data is not inverted when the result of counting the output result for each bit is greater than the reference value and the output of the indicator is the second level, when the result of counting the bits of the output result is less than the reference value and the output of the indicator is the first level, and when the result of counting the bits of the output result is less than the reference value, the output of the indicator is the second level, and the present input data is the tail flit.

In this case, the inverting signal may be transmitted to a receiving side by using flit type bits of the present input data. When the present input data is not inverted, the inverting signal may correspond to a flit type bit value indicating a data flit. When the present input data is inverted, the inverting signal may correspond to a value obtained by inverting the flit type bit value indicating the data flit.

The respective operation shown in FIG. 7 may be performed in an order shown in FIG. 7, in a reverse order, or at the same time.

The BIC generating method and apparatus according to an exemplary embodiment of the present invention may be used in generating a packet for on-chip interconnection. Also, the BIC generating method and apparatus according to an exemplary embodiment of the present invention may be applied to an NI. Also, in the BIC generating method and apparatus according to an exemplary embodiment of the present invention, inverting may be performed with respect to only a data flit.

The BIC generating method according to an exemplary embodiment the present invention may be embodied as a program instruction capable of being executed via various computer units and may be recorded in a computer-readable recording medium. The computer-readable medium may include a program instruction, a data file, and a data structure, separately or cooperatively. The program instructions and the media may be those specially designed and constructed for the purposes of the present invention, or they may be of the kind well-known and available to those skilled in the art of computer software arts. Examples of the computer-readable media include magnetic media (e.g., hard disks, floppy disks, and magnetic tapes), optical media (e.g., CD-ROMs or DVD), magneto-optical media (e.g., optical disks), and hardware devices (e.g., ROMs, RAMs, or flash memories, etc.) that are specially configured to store and perform program instructions. The media may also be transmission media such as optical or metallic lines, wave guides, etc. including a carrier wave transmitting signals specifying the program instructions, data structures, etc. Examples of the program instructions include both machine code, such as produced by a compiler, and files containing high-level language codes that may be executed by the computer using an interpreter. The hardware elements above may be configured to act as one or more software modules for implementing the operations of this invention.

An aspect of the present invention may provide a BIC generating method and apparatus capable of quickly generating a BIC by reducing a number of clock cycles consumed in determining whether data is inverted.

An aspect of the present invention may also provide a BIC generating method and apparatus capable of quickly generating a BIC by comparing bits when an inversion of previous input data is inverted is not recognized.

An aspect of the present invention may also provide a BIC generating method and apparatus capable of simply and efficiently counting bits by grouping two or more bits into one group for counting bits.

An aspect of the present invention may also provide a BIC generating method and apparatus capable of effectively generating a BIC by determining a suitable reference value when binding two or more bits into one group.

An aspect of the present invention may also provide a BIC generating method and apparatus capable of transmitting information about whether data is inverted to a receiving side without assigning additional bits, by using a flit type bit.

An aspect of the present invention may also provide a BIC generating method and apparatus capable of effectively generating a BIC when generating a packet for an NI to effectively perform on-chip networking.

Although a few exemplary embodiments of the present invention have been shown and described, the present invention is not limited to the exemplary embodiments as described herein. Instead, it would be appreciated by those skilled in the art that changes may be made to these exemplary embodiments without departing from the principles of the invention, the scope of which is defined by the claims.

## Claims

1. A bus inverting code generating apparatus comprising:
a bit comparator (210) which is arranged to compare present input data with previous input data for each bit and to output a bit comparison result;
a bit counter (220) which is arranged to count bits of the bit comparison result that is output by the bit comparator (210) and to output a bit count result;
an indicator (240) which is arranged to generate an indicator value and to toggle the indicator value if the bit count result that is output by the bit counter (220) is greater than a reference value; and
an inverting determiner (250) that is arranged to output an inverting signal which indicates whether the present input data is inverted based on the bit count result and the indicator value, and wherein the bit counter is arranged to count the bits of the output result by performing an add operation between groups by grouping the bits of the bit comparison result into groups of at least two bits.

2. The apparatus of claim 1, wherein, if the output of the indicator (240) is initialized as a second level,
the inverting determiner (250) is arranged to output the inverting signal to indicate inversion of the present input data if the bit count result is greater than the reference value and the indicator value is a first level, or the bit count result is less than the reference value and the indicator value is the first level.

3. The apparatus of claim 2, wherein, if the output of the indicator (240) value is initialized as the second level,
the inverting determiner (250) is arranged to output the inverting signal to indicate non-inversion of the present input data if the bit count result is greater than the reference value and the indicator value is the second level, or the output result of the bit counter is less than the reference value and the indicator value is the second level.

4. The apparatus of claim 1, wherein:
the groups of the bits of the bit comparison result include a number of bits that corresponds to a power of two; and
the predetermined reference value corresponds to a value obtained by dividing a product of a maximum value of a group among the groups of the bits and a number of bits of the present input data by twice a number of bits of the group.

5. The apparatus of any preceding claim, wherein the inverting signal is transmitted to a receiving side by using a flit type bit of the present input data.

6. The apparatus of claim 5, wherein the inverting signal corresponds to a flit type bit value that indicates a data flit if the present input data is not inverted or wherein the inverting signal corresponds to an inverted value of a flit type bit value that indicates a data flit if the present input data is inverted.

7. The apparatus of any preceding claim, further comprising a register (230) which is arranged to store the present input data,
and wherein the present input data that is stored in the register (230) is stored as the previous input data, and the register (230) is arranged to store new input data as the present input data.

8. The apparatus of claim 7, wherein the register (230) is arranged to replace the previous input data with the present input data each time the inverting determiner (250) outputs the inverting signal.

9. A bus inverting code generating method comprising:
generating a bit comparison result by comparing present input data with previous input data for each bit;
counting bits of the bit comparison result to generate a bit count result;
toggling an indicator output if the bit count result is greater than a reference value; and
outputting an inverting signal that indicates whether the present input data is inverted based on the bit count result and the indicator value, and wherein, in the counting bits of the bit comparison result, for each bit, the bits for the bit comparison result are counted by performing an add operation between groups by grouping the bits of the bit comparison result groups of at least two bits.

10. The method of claim 9, wherein, in the outputting the inverting signal, if the indicator value is initialized as a second level,
the inverting signal is output to indicate inversion of the present input data if the bit count result is greater than the reference value and the indicator value is a first level, or the bit count result is less than the reference value and the indicator value is the first level.

11. The method of claim 10, wherein, in the outputting the inverting signal, if the indicator value is initialized as the second level,
the inverting signal is output to indicate non-inversion of the present input data if the bit count result is greater than the reference value and the indicator value is the second level, or the bit count result is less than the reference value and the indicator value is the second level.

12. The method of claim 9, wherein:
the groups of the bits of the bit comparison result includes a number of bits that corresponds to a power of two; and
the predetermined reference value corresponds to a value obtained by dividing a product of a maximum value of a group among the groups of the bits and a number of bits of the present input data by twice a number of bits of the group.

13. A computer program comprising computer program code means adapted to perform all of the steps of any of claims 9 to 12 when the program is run on a computer.

14. A computer program as claimed in claim 13 embodied on a computer readable medium.
